# EUROPEAN PATENT SPECIFICATION

(11) **EP 3 193 325 B1**
(45) Date of publication and mention of the grant of the patent: **11.11.2020**
(21) Application number: 16207554.3
(22) Date of filing: 30.12.2016
(51) Int. Cl.: G09G 3/36, G11C 19/28

(54) **LIQUID CRYSTAL DISPLAY DEVICE**
FLÜSSIGKRISTALLANZEIGEVORRICHTUNG
AFFICHAGE À CRISTAUX LIQUIDES

(30) Priority: 30.12.2015 KR 20150190179
(43) Date of publication of application: 19.07.2017
(73) Proprietor: LG Display Co., Ltd., Seoul, 07336 (KR)
(72) Inventor: LEE, Jung-Hyun, 10845 Gyeonggi-do (KR); MOON, Tae-Woong, 10920 Gyeonggi-do (KR)
(74) Representative: Ter Meer Steinmeister & Partner

(56) References cited:
- EP-A2- 1 492 078
- WO-A1-2015/137710
- CN-A- 104 849 928
- US-A1- 2014 043 306

## Description

### BACKGROUND

### FIELD OF THE DISCLOSURE

The present disclosure relates to a display device, and more particularly, to a display having a narrow bezel.

### DISCUSSION OF THE RELATED ART

A liquid crystal display (LCD) device includes a display panel, a data driving unit for providing data signals to data lines of the display panel, a gate driving unit for providing gate signals to gate lines of the display panel, and a timing controller for controlling the data driving unit and the gate driving unit.

In the LCD device, the gate driving unit and the data driving unit are generally manufactured in an integrated circuit form and attached to the display panel in a TCP (tape carrier package) or COF (chip on film) type.

Therefore, the number of components increases, and manufacturing processes and costs also rise due to an increase in the number of components. This causes a problem in decreasing a weight and size of the LCD device. To solve the problem, a GIP (gate in panel) type LCD device, in which the gate driving unit is formed in the display panel, has been suggested.

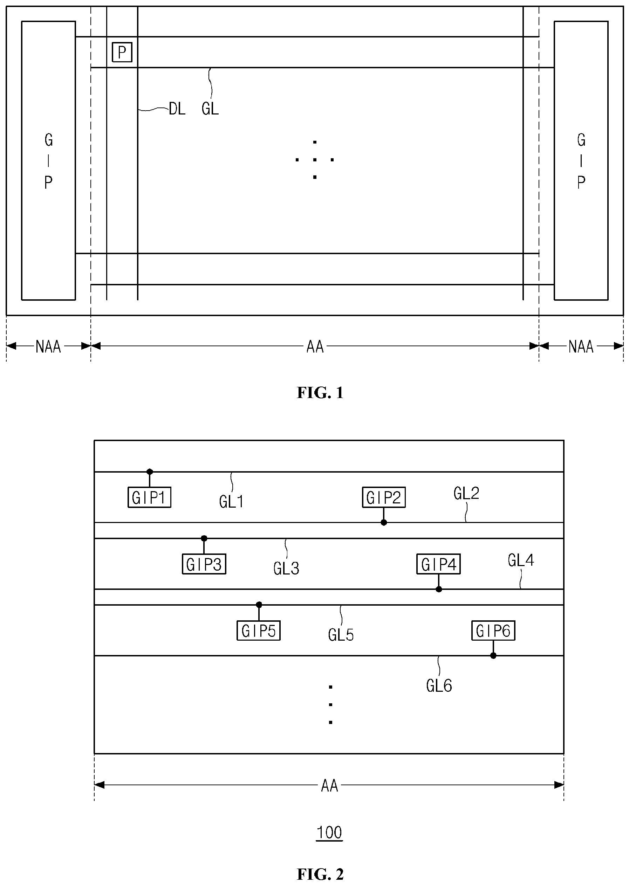

FIG. 1 is a plan view of a display panel of a GIP type LCD device according to a related art.

In FIG. 1, a display panel 10 of a GIP type LCD device according to the related art includes a display area AA and non-display areas NAA. The non-display areas NAA are disposed at outer sides of the display area AA, for example, at left and right sides of the display area AA, respectively.

Here, pixels P defined by gate lines GL and data lines DL crossing each other are disposed in the display area AA of the display panel 10, and GIP circuits each including signal lines (not shown) and transistors (not shown) are disposed in respective non-display areas NAA.

Meantime, recently, in the LCD device, it is required to narrow a bezel, which is defined as a width of the non-display area NAA, with pursuing a light weight and thin thickness for a slim design of a final product such as monitors or TVs.

However, as stated above, in the GIP type LCD device according to the related art, since the GIP circuits GIP, each of which includes the signal lines (not shown) and the transistors (not shown), are formed in the non-display areas NAA at left and right sides of the display area AA, there is a limitation on achieving a narrow bezel.
US 2014/043306 A1 describes a display device including a panel having a display area and first, second, third and fourth non-display areas formed at an outer portion of the display area, said first non-display area facing the second non-display area, and the third non-display area facing the fourth non-display area; a data driver disposed in the first non-display area, and configured to drive a plurality of data lines provided in a first direction in the display area; a gate driver disposed in the second non-display area and configured to drive a plurality of gate lines provided in a second direction vertical to the first direction in the display area; a timing controller configured to drive the data driver and the gate driver; and a plurality of link lines in the display area and extending from the gate driver and provided in parallel to the data lines respectively connected to the gate lines.
CN 104 849 928 A discloses a TFT array substrate, a display panel and a display device. A grid driving circuit and grid driving circuit elements are integrated into a display area.
US 2016/307937 A1 discloses a thin-film transistor (TFT) array substrate which comprises a substrate having at least a display region; and a plurality of top-gated thin-film transistors formed over the substrate. The thin-film transistor (TFT) array substrate also comprises a plurality of scan lines and a plurality of data lines formed over the substrate in the display region and defining a plurality of sub-pixels, wherein a plurality of pre-reserved blank regions are configured among the scan lines, the data lines, and the plurality of sub-pixels in the display region; and a gate driver circuit formed over the substrate in the display region and disposed in the pre-reserved blank regions in the display region.
EP 1 492 078 A2 discloses a liquid crystal display apparatus which includes a liquid crystal panel assembly having pixels arranged in a matrix form, which have a first group of pixels and a second group of pixels, gate lines having a first group of gate lines and a second group of gate lines that are connected with the first group of pixels and the second group of pixels, respectively, and data lines each of which is connected with one of the first group of pixels and one of the second group of pixels in every row of the matrix form.
WO 2015/137710 A1 discloses a display device, which decreases power consumption. It comprises a gate driver including a plurality of stages sequentially driven according to a start signal, wherein the gate driver controls an output of a scan signal from at least one of the plurality of stages according to an enable signal.

### SUMMARY

Accordingly, the present disclosure is directed to a display device that substantially obviates one or more of the problems due to limitations and disadvantages of the related art.

An object of the present disclosure is to provide a display device that has a narrow bezel by disposing signal lines and transistors of a GIP circuit.

Additional features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings. The objects are solved by the features of the independent claim.

According to one aspect, there is provided a liquid crystal display device including a display panel preferably including a display area and a non-display area, wherein in the display area, m/2 (m is a positive even number) data lines of a first direction and 2n (n is an integer more than 5) gate lines of a second direction cross each other to thereby define m × n pixels; and 2n GIP circuits in the display area and each including signal lines and transistors, wherein two gate lines are disposed between adjacent two pixel rows, and two pixel columns are disposed between adjacent two data lines, and wherein the signal lines and the transistors are separately disposed between the two pixel columns. Preferably, odd GIP circuits of the GIP circuits output odd gate lines of the gate lines, and even GIP circuits of the GIP circuits output even gate lines of the gate lines. Preferably, the signal lines include at least one of first and second clock signal lines, a start signal line, a reset signal line and a low level voltage line. Preferably, the signal lines are disposed on a same layer as the data lines. Preferably, the GIP circuit further includes first and second node lines. The first and second node lines may be disposed between adjacent two pixel rows. Preferably, the first and second node lines are spaced apart from the gate lines. Preferably, the first and second node lines are disposed on a same layer as the gate lines. Preferably, the first and second node lines overlap the gate lines. Preferably, the first and second node lines are disposed on a different layer from the gate lines. Preferably, the transistors include at least one of: a first transistor connected to the start signal line and the first node line; a second transistor connected to the first node line and the low level voltage line; a third transistor connected to the first clock signal line and the first node line; a fourth transistor connected to the second clock signal line, the low level voltage line and the third transistor; and a fifth transistor connected to the first clock signal line and the third transistor. Preferably, the liquid crystal display device further comprises a data driving unit in the non-display area and outputting data signals to the data lines.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a plan view of a display panel of a GIP type LCD device according to a related art;
FIG. 2 is a plan view of a display panel of a GIP type LCD device according to an embodiment of the present disclosure;
FIG. 3 is a schematic view of illustrating a plurality of GIP circuits according to the embodiment of the present disclosure;
FIG. 4 is a view of schematically illustrating the first GIP circuit according to the embodiment of the present disclosure; and
FIG. 5 is a view of a display panel including GIP circuits in a display area according to the embodiment of the present disclosure.

### DETAILED DESCRIPTION

Reference will now be made in detail to the embodiment of the disclosure, an example of which is illustrated in the accompanying drawings.

FIG. 2 is a plan view of a display panel of a GIP type LCD device according to an embodiment of the present disclosure.

In FIG. 2, the display panel 100 of a GIP type LCD device according to the embodiment of the present disclosure includes a display area AA and non-display areas (not shown) at outer sides of the display area AA.

More specifically, a plurality of pixels (not shown), which are defined by a plurality of gate lines GL1 to GL6 and a plurality of data lines (not shown) crossing each other, are disposed in the display area AA of the display panel 100.

Particularly, a plurality of GIP circuits GIP1 to GIP6, each of which includes a plurality of signal lines (not shown) and a plurality of transistors (not shown), are disposed in the display area AA of the display panel 100.

In the embodiment of the present disclosure, a narrow bezel can be achieved by disposing the GIP circuits GIP1 to GIP6 in the display area AA while the GIP circuits are disposed in the non-display areas NAA of FIG. 1 at the left and right sides of the display area AA of FIG. 1 in the LCD device according to the related art. This will be described in more detail later.

Meanwhile, although more gate lines and GIP circuits may be disposed in the display area AA of the display panel 100, for convenience of explanation, six gate lines GL1 to GL6 and six GIP circuits GIP1 to GIP6 are shown in the figure.

At this time, odd GIP circuits GIP1, GIP3 and GIP5 of the GIP circuits GIP1 to GIP6 output gate signals to odd gate lines GL1, GL3 and GL5 of the gate lines GL1 to GL6, respectively, and even GIP circuits GIP2, GIP4 and GIP6 of the GIP circuits GIP1 to GIP6 output gate signals to even gate lines GL2, GL4 and GL6 of the gate lines GL1 to GL6, respectively.

In the meantime, although not shown in the figure, a data driving unit (not shown) may be further disposed in the non-display area (not shown) at an upper or lower side of the display area AA.

At this time, the data driving unit (not shown) outputs data signals to the data lines (not shown) in the display area AA.

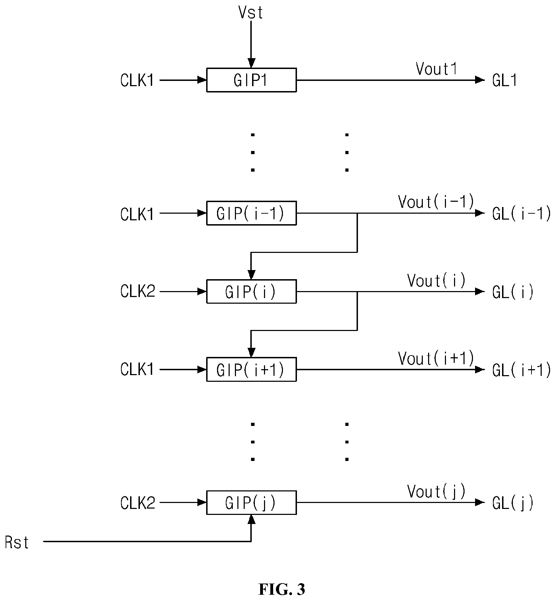

FIG. 3 is a schematic view of illustrating a plurality of GIP circuits according to the embodiment of the present disclosure.

In FIG. 3, the GIP circuits GIP1, ..., GIP(i-1), GIP(i), GIP(i+1), ..., and GIP(j) respectively output gate signals Vout1, ..., Vout(i-1), Vout(i), Vout(i+1), ..., and Vout(j), each of which has one high level during a frame, wherein i is an integer larger than 2, and j is an integer larger than 4.

At this time, first GIP circuit to (j)th GIP circuit GIP1 to GIP(j) each receive at least one of a plurality of clock signals CLK1 and CLK2 and sequentially output the gate signals Vout1, ..., Vout(i-1), Vout(i), Vout(i+1), ..., and Vout(j) having the high level to the gate lines GL1, ..., GL(i-1), GL(i), GL(i+1), ..., and GL(j), respectively, wherein i is an integer larger than 2, and j is an integer larger than 4.

In addition, each of the plurality of clock signals CLK1 and CLK2 partially overlaps the next clock signal, and the plurality of clock signals CLK1 and CLK2 are sequentially and repeatedly applied to the GIP circuits GIP1, ..., GIP(i-1), GIP(i), GIP(i+1), ..., and GIP(j). For example, each of the plurality of clock signals CLK1 and CLK2 may overlap 2/3 of a high level section of the next clock signal. Here, although two clock signals CLK1 and CLK2 are used, the number of clock signals CLK1 and CLK2 are not limited to this.

The gate signals Vout1, ..., Vout(i-1), Vout(i), Vout(i+1), ..., and Vout(j), which are respectively outputted from the GIP circuits GIP1, ..., GIP(i-1), GIP(i), GIP(i+1), ..., and GIP(j), are sequentially provided to the gate lines GL1, ..., GL(i-1), GL(i), GL(i+1), ..., and GL(j) of a display panel (not shown) displaying images.

More specifically, the first GIP circuit GIP1 outputs the first gate signal Vout1 having the high level to the first gate line GL1, ..., the (i-1)th GIP circuit GIP(i-1) outputs the (i-1)th gate signal Vout(i-1) having the high level to the (i-1)th gate line GL(i-1), the (i)th GIP circuit GIP(i) outputs the (i)th gate signal Vout(i) having the high level to the (i)th gate line GL(i), the (i+1)th GIP circuit GIP(i+1) outputs the (i+1)th gate signal Vout(i+1) having the high level to the (i+1)th gate line GL(i+1), ..., and the (j)th GIP circuit GIP(j) outputs the (j)th gate signal Vout(j) having the high level to the (j)th gate line GL(j).

First, since there is no previous GIP circuit before the first GIP circuit GIP1, the first GIP circuit GIP1 cannot receive a gate signal of the previous GIP circuit as a starting signal to start. Thus, the first GIP circuit GIP1 receives a start signal Vst and starts.

Accordingly, the start signal Vst is applied to the first GIP circuit GIP1, the first GIP circuit GIP1 outputs the first gate signal Vout1 of the high level using the first clock signal CLK1, ..., the (i-1)th gate signal Vout(i-1) of the high level outputted from the (i-1)th GIP circuit GIP(i-1) is provided to the (i)th GIP circuit GIP(i) to thereby start the (i)th GIP circuit GIP(i), and the (i)th GIP circuit GIP(i) outputs the (i)th gate signal Vout(i) of the high level using the second clock signal CLK2 (in the figure, although the second clock signal CLK2 is used, the first clock signal CLK1 or another clock signal may be used).

Next, the (i)th gate signal Vout(i) of the high level outputted from the (i)th GIP circuit GIP(i) is provided to the (i+1)th GIP circuit GIP(i+1) to thereby start the (i+1)th GIP circuit GIP(i+1), and the (i+1)th GIP circuit GIP(i+1) outputs the (i+1)th gate signal Vout(i+1) of the high level using the first clock signal CLK1 (in the figure, although the first clock signal CLK1 is used, the first clock signal CLK1 or another clock signal may be used), ..., the (j)th GIP circuit GIP(j) outputs the (j)th gate signal Vout(j) of the high level using the second clock signal CLK2 (in the figure, although the second clock signal CLK2 is used, the first clock signal CLK1 or another clock signal may be used).

When the (j)th gate signal Vout(j) is outputted from the (j)th GIP circuit GIP(j) where one frame ends, the (j)th GIP circuit GIP(j) receives a reset signal Rst and is initialized such that the first gate signal Vout1 is outputted from the first GIP circuit GIP1 where the next frame starts.

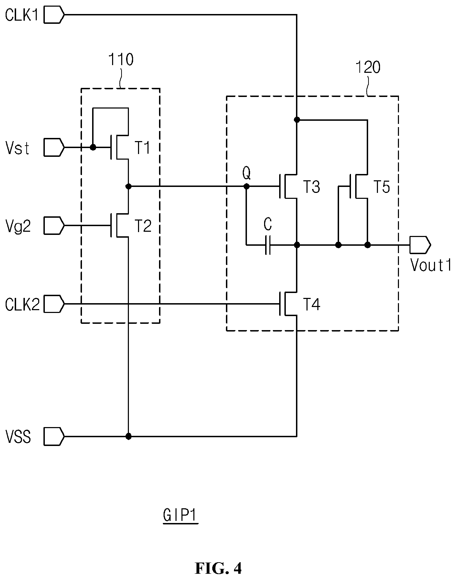

FIG. 4 is a view of schematically illustrating the first GIP circuit according to the embodiment of the present disclosure.

In FIG. 4, the first GIP circuit GIP1 includes a control unit 110 controlling a first node Q and an output unit 120 outputting the first gate signal Vout1 corresponding to the first clock signal CLK1 depending on a voltage state at the first node Q.

Here, the control unit 110 controls the voltage state of the first node Q such that the first gate signal Vout1 corresponding to the first clock signal CLK1 is outputted from the output unit 120.

To do this, the control unit 110 includes a first transistor T1 connected between a start signal (Vst) input terminal and the first node Q and a second transistor T2 connected between the first node Q, a second gate signal Vg2 input terminal and a low level voltage VSS input terminal.

Here, drain and gate of the first transistor T1 are connected to each other, and the first transistor T1 functions as a diode. That is, a voltage at the drain of the first transistor T1 is inputted to source, and on the contrary to this, a voltage at the source is not inputted to the drain.

Therefore, the first transistor T1 applies the start signal Vst to the first node Q, and at the same time, the first transistor T1 prevents a voltage charged at the first node Q from being discharged to the outside through the first transistor T1.

In addition, the second transistor T2 initializes the first node Q. At this time, the second transistor T2 turns on by the second gate signal Vg2 and charges the first node Q with the low level voltage VSS.

According to this, the first node Q can be charged by the start signal Vst of a high level at the next frame.

The output unit 120 outputs a high level of the first gate signal Vout1 or a low level of the first gate signal Vout1 depending on the voltage state of the first node Q.

To do this, the output unit 120 includes a third transistor T3 connected between a first clock signal CLK1 input terminal, the first node Q and a first gate signal Vout1 output terminal, a fourth transistor T4 connected between a second clock signal CLK2 input terminal, the low level voltage VSS input terminal and source of the third transistor T3, a fifth transistor T5 connected between drain of the third transistor T3 and the first gate signal Vout1 output terminal, and a capacitor C connected between the first node Q and the source of the third transistor T3.

At this time, the third transistor T3 turns on by a voltage of a high level charged at the first node Q and outputs the first gate signal Vout1 corresponding to a high level of the first clock signal CLK1.

Additionally, the first gate signal Vout1 is inputted to the second GIP circuit (not shown) as a starting signal. Then, the second GIP circuit outputs the second gate signal Vg2.

Moreover, the second gate signal Vg2 is inputted to the second gate signal Vg2 input terminal, and the second transistor T2 turns on by the second gate signal Vg2, whereby the first node Q is charged by the low level voltage VSS.

Furthermore, source and gate of the fifth transistor T5 are connected to each other, and the fifth transistor T5 functions as a diode. At this time, the fifth transistor T5 turns on if the high level of the first clock signal is applied to the gate of the fifth transistor T5, and the fifth transistor T5 turns off if the low level voltage VSS is applied to the gate of the fifth transistor T5.

In addition, the capacitor C is charged by a voltage level of the start signal Vst when the start signal Vst of the high level is inputted to the gate of the first transistor T1 and the first transistor T1 turns on.

Then, when the capacitor C is charged with a voltage more than a threshold voltage between the gate and source of the third transistor T3 and the first clock signal CLK1 is high, bootstrapping occurs. A voltage larger than the high level of the start signal Vst is charged at the first node Q, and the voltage of the first node Q is definitely high. Thus, the third transistor T3 turns on.

Moreover, the fourth transistor T4 turns on by the second clock signal CLK2 and outputs the low level voltage VSS to the first gate signal Vout1 output terminal.

At this time, the low level voltage VSS is charged at the first node Q by the second transistor T2, which turns on by the second gate signal Vg2, the third transistor T3 turns off, and initialization is accomplished.

These processes are repeatedly performed at each frame.

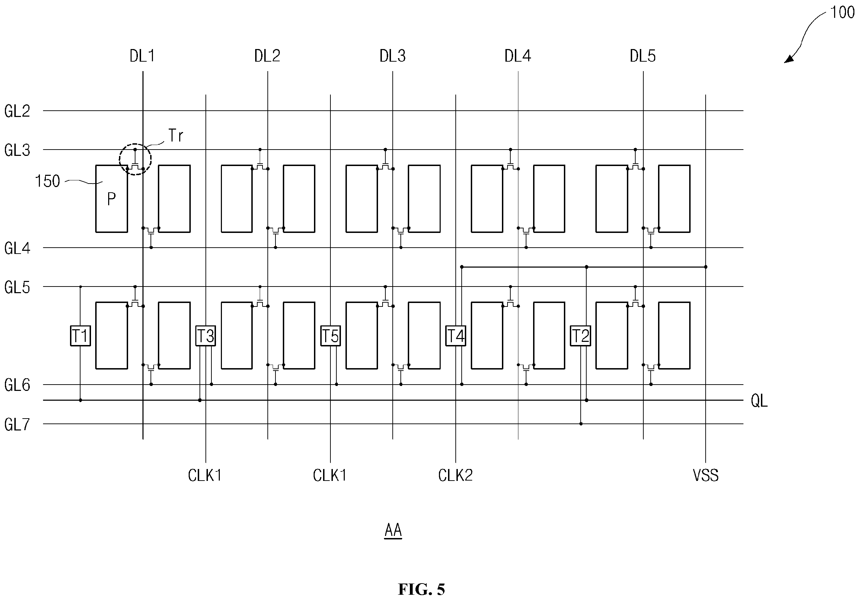

FIG. 5 is a view of a display panel including GIP circuits in a display area according to the embodiment of the present disclosure.

In the display area AA of the display panel 100, m/2 (m is a positive even number) data lines extending in a first direction and 2n (n is an integer more than 5) gate lines extending in a second direction cross each other to thereby define m × n pixels, and 2n GIP circuits are disposed. However, for convenience of explanation, second to seventh gate lines GL2 to GL7, first to fifth data lines DL1 to DL5 and one GIP circuit are shown in the figure. At this time, the GIP circuit corresponds to the sixth GIP circuit GIP6 of FIG. 2 wherein i is 6.

In FIG. 5, two pixel columns are disposed between adjacent two of the first to fifth data lines DL1 to DL5, and two of the second to seventh gate lines GL2 to GL7 are disposed between adjacent two pixel rows.

In addition, each pixel includes a pixel electrode P and a thin film transistor Tr. A data signal from one of the first to fifth data lines DL1 to DL5 is provided to two pixel columns, which are adjacent to each other with the one of the first to fifth data lines DL1 to DL5 therebetween.

At this time, there is no data line between the two pixel columns, which are adjacent to each other with the one of the first to fifth data lines DL1 to DL5 therebetween, and the next two pixel columns.

Here, signal lines CLK, CLK2, VSS, Vst of FIG. 3 and Rst of FIG. 3 and transistors T1 to T5, which are included in the GIP circuit, are separately disposed between the two pixel columns and the next two pixel columns where there is no data line.

Namely, the LCD device according to the present invention utilizes an area where the data lines DL1 to DL5 are not disposed in the display area AA. Accordingly, since it is not necessary to arrange an additional area for the signal lines CLK1, CLK2, VSS, Vst and Rst of FIG.3 and the transistors T1 to T5 in the display area AA, an aperture ratio can be prevented from being lowered.

At this time, the signal lines CLK1, CLK2, VSS, Vst and Rst of FIG.3 include first and second clock signal lines CLK1 and CLK2, a start signal line Vst of FIG. 3, a reset signal line Rst of FIG.3, and a low level voltage line VSS.

In addition, the GIP circuit further includes a first node line QL and a second node line (not shown). Each of the first node line QL and the second node line may be disposed between adjacent two pixel rows.

Meanwhile, the signal lines CLK1, CLK2, VSS, Vst and Rst of FIG.3 extend in the first direction, and may be formed of a same material on a same layer as the data lines DL1 to DL5.

Moreover, the first node line QL and the second node line extend in the second direction. If the first node line QL and the second node line are spaced apart from the gate lines GL2 to GL7, the first node line QL and the second node line may be formed of the same material on the same layer as the gate lines GL2 to GL7. Alternatively, if the first node line QL and the second node line overlap the gate lines GL2 to GL7, the first node line QL and the second node line may be formed of a different material on a different layer from the gate lines GL2 to GL7.

Furthermore, the transistors T1 to T5 include first to fifth transistors T1 to T5.

More specifically, gate and drain electrodes of the first transistor T1 are connected to the fifth gate line GL5, and a source electrode of the first transistor T1 is connected to the first node line QL.

At this time, the first transistor T1 receives a gate signal supplied from the fifth gate line GL5 as a starting signal and inputs it to the first node line QL.

In the meantime, since there is no previous GIP circuit before the first GIP circuit GIP1 of FIG. 3, the first transistor T1 of the first GIP circuit GIP1 of FIG. 3 cannot receive a gate signal outputted from the previous GIP circuit as a starting signal to start. Thus, the gate electrode of the first transistor T1 of the first GIP circuit GIP1 of FIG. 3 is connected to the start signal line Vst of FIG. 3 and receives a start signal supplied from the start signal line Vst of FIG. 3 to start.

In addition, the gate and drain electrodes of the first transistor T1 are connected to each other, and the first transistor T1 functions as a diode. A voltage charged at the first node line QL is prevented from being discharged to the outside through the first transistor T1.

Moreover, a drain electrode of the second transistor T2 is connected to the first node line QL, a source electrode of the second transistor T2 is connected to the low level voltage line VSS, and a gate electrode of the second transistor T2 is connected to the seventh gate line GL7.

At this time, the second transistor T2 turns on by a gate signal supplied from the seventh gate line GL7 and inputs a low level voltage supplied from the low level voltage line VSS to the first node line QL.

Like this, a next frame is prepared by charging the first node line QL with the low level voltage.

Additionally, a source electrode of the third transistor T3 is connected to the sixth gate line GL6, a drain electrode of the third transistor T3 is connected to the first clock signal line CLK1, and a gate electrode of the third transistor T3 is connected to the first node line QL.

At this time, the third transistor T3 turns on by a high level voltage charged at the first node line QL and outputs a gate signal corresponding to the clock signal supplied from the first clock signal line CLK1 to the sixth gate line GL6.

In the meantime, as stated above, if the low level voltage is charged at the first node line QL by the second transistor T2 turning on, the third transistor T3 turns on, and the initialization is accomplished.

In addition, a gate electrode of the fourth transistor T4 is connected to the second clock signal line CLK2, a source electrode of the forth transistor T4 is connected to the low level voltage line VSS, and a drain electrode of the fourth transistor T4 is connected to the sixth gate line GL6 and the source electrode of the third transistor T3.

At this time, the fourth transistor T4 turns on by a clock signal supplied from the second clock signal line CLK2 and outputs the low level voltage supplied from the low level voltage line VSS to the sixth gate line GL6.

Moreover, a drain electrode of the fifth transistor T5 is connected to the first clock signal line CLK1, and a gate electrode and a source electrode of the fifth transistor T5 are connected to the sixth gate line GL6 and the drain electrode of the third transistor T3.

At this time, the fifth transistor T5 turns on a clock signal supplied from the first clock signal line CLK1 and outputs a gate signal corresponding to the clock signal to the sixth gate line GL6, and the fifth transistor T5 turn off by the low level voltage supplied from the low level voltage line VSS and outputs the low level voltage to the sixth gate line GL6.

Meanwhile, the gate and source electrodes of the fifth transistor T5 are connected to each other and the fifth transistor T5 functions as a diode.

In the above processes, although it is explained to output a gate signal from a sixth GIP circuit GIP6 of FIG. 3 disposed in the display area AA to the sixth gate line GL6, other GIP circuits may output gate signals to respective gate lines according to the same processes as the above processes.

Hereinafter, arrangement structures and connection relations of the first to fifth transistors T1 to T5, the signal lines CLK1, CLK2 and VSS connected to the first to fifth transistors T1 to T5, and the first node line QL will be explained with reference to FIG. 5.

First, since the sixth GIP circuit GIP6 of FIG. 3 outputs the gate signal to the sixth gate line GL6, the first to fifth transistors T1 to T5 of the sixth GIP circuit GIP6 of FIG. 3 are disposed between the fifth gate line GL5 and the sixth gate line GL6.

At this time, the first transistor T1 is disposed at a left side of the first pixel column connected to the first data line DL1, the second transistor T2 is disposed between two pixels P, which are located between the fourth and fifth data lines DL4 and DL5, the third transistor T3 is disposed between the two pixels P, which are located between the first and second data lines DL1 and DL2, the fourth transistor T4 is disposed between the two pixels P, which are located between the third and fourth data lines DL3 and DL4, and the fifth transistor T5 is disposed between the two pixels P, which are located between the second and third data lines DL2 and DL3.

In addition, the first clock signal line CLK1 is disposed between the two pixel columns, which are located between the first and second data lines DL1 and DL2, and also disposed between the two pixel columns, which are located between the second and third data lines DL2 and DL3.

At this time, the first clock signal line CLK1 are connected to the third and fifth transistors T3 and T5.

Moreover, the second clock signal line CLK2 is disposed between the two pixel columns, which are located between the third and fourth data lines DL3 and DL4, and is connected to the fourth transistor T4.

Furthermore, the low level voltage line VSS is disposed at a right side of the pixel column, which is located at a right side of the fifth data line DL5.

At this time, the low level voltage line VSS extends parallel to the fourth and fifth gate lines GL4 and GL5 between the fourth and fifth gate lines GL4 and GL5 and is connected to the second and fourth transistors T2 and T4.

Additionally, the first node line QL is disposed parallel to the sixth and seventh gate lines GL6 and GL7 between the sixth and seventh gate lines GL6 and GL7 and is connected to the first, second and third transistors T1, T2 and T3.

In the above embodiment, two clock signals are used. However, the number of the clock signals is not limited to this and is changeable.

Meanwhile, the gate line from which the first transistor T1 receives the starting signal and the gate line from which the second transistor T2 receives the gate signal to turn on may be changed.

For example, when eight clock signals are used, the first transistor T1 may receive the starting signal from the (i-4)th gate line, and the second transistor T2 may receive the gate signal of the (i+4)th gate line to turn on. That is, since i is 6, the gate electrode of the first transistor T1 may be connected to the second gate line, and the gate electrode of the second transistor T2 may be connected to the tenth gate line.

At this time, the gate electrode of the first transistor T1 of each of the first to fourth GIP circuits may be connected to the start signal line Vst of FIG. 3, and the gate electrode of the second transistor T2 of each of the (j-3)th to (j)th GIP circuits may be connected to the reset signal line Rst of FIG. 3.

Like this, the narrow bezel can be achieved by disposing the signal lines CLK1, CLK2, VSS, Vst of FIG. 3 and Rst of FIG. 3 and the transistors T1 to T5 of the GIP circuits, which were disposed at the non-display areas NAA of FIG. 1 at the left and right sides of the display area AA of FIG. 1, in the display area AA.

In addition, since the signal lines CLK1, CLK2, VSS, Vst of FIG. 3 and Rst of FIG. 3 and the transistors T1 to T5 of the GIP circuits are formed together when the data lines DL1 to DL5, the gate lines GL2 and GL7, and the thin film transistors Tr of the pixels P are formed, the manufacturing processes are simplified, and the manufacturing costs are decreased.

It will be apparent to those skilled in the art that various modifications and variations can be made in a display device of the present disclosure without departing from the scope of the invention. Thus, it is intended that the present disclosure covers the modifications and variations of this invention provided they come within the scope of the appended claims.

## Claims

1. A display device comprising:
a display panel (100) including a display area (AA) with m × n pixels, each pixel including a thin film transistor (Tr), and a non-display area (NAA),
m/2 data lines (DL) arranged in the display area (AA) in a first direction, with m being a positive even number,
2n gate lines (GL) arranged in the display area (AA) in a second direction, with n being an integer more than 5, wherein the gate lines (GL) and the data lines (DL) cross each other for defining the m × n pixels arranged in m pixel columns and n pixel rows; and
2n gate-in-panel, GIP, circuits arranged in the display area (AA), the GIP circuit including transistors (T1, ..., T5),
wherein two gate lines are disposed between adjacent two pixel rows, and two pixel columns are disposed between adjacent two data lines, and
wherein the transistors (T1, ..., T5) are arranged between pixel columns disposed between adjacent two data lines,
wherein a first GIP circuit (GIP1) configured to output a gate signal to a first gate line (GL1) includes:
a first transistor (T1) having a gate thereof connected to a start signal line (Vst) and a first terminal thereof connected to a first node line (Q1), wherein the gate and a second terminal of the first transistor (T1) are connected to each other;
a second transistor (T2) having a gate thereof connected to a gate signal input terminal (Vg2), a first terminal thereof connected to the first node line (Q1), and a second terminal thereof connected to a low level voltage line (VSS);
a third transistor (T3) having a first terminal thereof connected to a first clock signal line (CLK1) and a gate thereof connected to the first node line (Q1);
a fourth transistor (T4) having a gate connected to a second clock signal line (CLK2), a first terminal thereof connected to the low level voltage line (VSS), and a second terminal thereof connected to a second terminal of the third transistor (T3);
a fifth transistor (T5) having a first terminal thereof connected to the first clock signal line (CLK1) and a second terminal thereof connected to the second terminal of the third transistor (T3), wherein a gate and the second terminal of the fifth transistor (T5) are connected to each other; and
a capacitor (C) connected between the first node line (Q1) and the second terminal of the third transistor (T3);
wherein the signal lines are arranged between pixel columns disposed between adjacent two data lines.

2. The display device of claim 1, wherein output of odd GIP circuits of the 2n GIP circuits is provided to odd gate lines of the 2n gate lines, and output of even GIP circuits of the 2n GIP circuits is provided to even gate lines of the 2n gate lines.

3. The display device of claim 2, wherein the signal lines are disposed on a same layer as the data lines (DL) and/or are made of a same material as the data lines (DL).

4. The display device according to any one of the preceding claims 1 to 3, wherein the signal lines extend in the first direction.

5. The display device according to any one of the preceding claims, wherein the GIP circuit further includes at least one of a first and second node lines disposed between adjacent two pixel rows.

6. The display device of claim 5, wherein at least one of the first and second node lines is spaced apart from the gate lines (GL) and/or is disposed on a same layer as the gate lines (GL) and/or is made of a same material as the gate lines (GL).

7. The display device of claim 5, wherein at least one of the first and second node lines is arranged overlapping one of the gate lines (GL) and is disposed on a different layer from the gate lines (GL).

8. The display device according to any one of the preceding claims 5 to 7, wherein the first and/or second node lines extend in the second direction.

9. The display device of claim 1, wherein an ith GIP circuit configured to output a gate signal to an ith gate line, with i being an integer larger than 2, includes:
a first transistor connected to a (i-1)th gate line and the first node line (QL);
a second transistor connected to the first node line (QL) and the low level voltage line (VSS);
a third transistor connected to the first clock signal line (CLK1) and the first node line (QL);
a fourth transistor connected to the second clock signal line (CLK2), the low level voltage line (VSS) and the third transistor; and
a fifth transistor connected to the first clock signal line (CLK1) and the third transistor.

10. The display device according to any one of the preceding claims, wherein each transistor of one GIP circuit is arranged between two pixel columns that are disposed between adjacent two data lines (DL) and/or wherein the transistors of one GIP circuit are arranged in the second direction along one of the gate lines (GL).

11. The display device according to any one of the preceding claims, further comprising a data driving unit in the non-display area (NAA) and configured to output data signals to the data lines (DL).

12. The display device according to any one of the preceding claims, wherein two pixels of one pixel row are connected to a same data line arranged therebetween and/or wherein pixels of one pixel row are alternately connected to an odd and an even gate line.

## Patentansprüche

1. Anzeigevorrichtung, die Folgendes umfasst:
eine Anzeigetafel (100), die einen Anzeigebereich (AA) mit m × n Pixeln, wobei jedes Pixel einen Dünnschichttransistor (Tr) enthält, und einen nicht anzeigenden Bereich (NAA) enthält,
m/2 Datenleitungen (DL), die in einer ersten Richtung im Anzeigebereich (AA) angeordnet sind, wobei m eine positive, gerade Zahl ist,
2n Gate-Leitungen (GL), die in einer zweiten Richtung im Anzeigebereich (AA) angeordnet sind, wobei n eine Ganzzahl größer als 5 ist, wobei die Gate-Leitungen (GL) und die Datenleitungen (DL) einander kreuzen, um die m × n Pixel zu definieren, die in m Pixelspalten und n Pixelzeilen angeordnet sind; und
2n in die Tafel integrierte Gate-Schaltungen, GIP-Schaltungen, die im Anzeigebereich (AA) angeordnet sind, wobei die GIP-Schaltung Transistoren (T1, ..., T5) enthält,
wobei zwei Gate-Leitungen zwischen zwei benachbarten Pixelzeilen angeordnet sind und zwei Pixelspalten zwischen zwei benachbarten Datenleitungen angeordnet sind, und
wobei die Transistoren (T1, ..., T5) zwischen Pixelspalten angeordnet sind, die zwischen zwei benachbarten Datenleitungen angeordnet sind,
wobei eine erste GIP-Schaltung (GIP1), die konfiguriert ist, ein Gate-Signal an eine erste Gate-Leitung (GL1) auszugeben, Folgendes enthält:
einen ersten Transistor (T1), wobei ein Gate davon mit einer Startsignalleitung (Vst) verbunden ist und ein erster Anschluss davon mit einer ersten Knotenleitung (Q1) verbunden ist, wobei das Gate und ein zweiter Anschluss des ersten Transistors (T1) miteinander verbunden sind;
einen zweiten Transistor (T2), wobei ein Gate davon mit einem Gate-Signaleingangsanschluss (Vg2) verbunden ist, ein erster Anschluss davon mit der ersten Knotenleitung (Q1) verbunden ist und ein zweiter Anschluss davon mit einer Niederpegelspannungsleitung (VSS) verbunden ist;
einen dritten Transistor (T3), wobei ein erster Anschluss davon mit einer ersten Taktsignalleitung (CLK1) verbunden ist und ein Gate davon mit der ersten Knotenleitung (Q1) verbunden ist;
einen vierten Transistor (T4), wobei ein Gate mit einer zweiten Taktsignalleitung (CLK2) verbunden ist, ein erster Anschluss davon mit der Niederpegelspannungsleitung (VSS) verbunden ist und ein zweiter Anschluss davon mit einem zweiten Anschluss des dritten Transistors (T3) verbunden ist;
einen fünften Transistor (T5), wobei ein erster Anschluss davon mit der ersten Taktsignalleitung (CLK1) verbunden ist und ein zweiter Anschluss davon mit dem zweiten Anschluss des dritten Transistors (T3) verbunden ist, wobei ein Gate und der zweite Anschluss des fünften Transistors (T5) miteinander verbunden sind; und
einen Kondensator (C), der zwischen der ersten Knotenleitung (Q1) und dem zweiten Anschluss des dritten Transistors (T3) verbunden ist;
wobei die Signalleitungen zwischen Pixelspalten angeordnet sind, die zwischen zwei benachbarten Datenleitungen angeordnet sind.

2. Anzeigevorrichtung nach Anspruch 1, wobei der Ausgang von ungeraden GIP-Schaltungen der 2n GIP-Schaltungen ungeraden Gate-Leitungen der 2n Gate-Leitungen bereitgestellt wird und der Ausgang von geraden GIP-Schaltungen der 2n GIP-Schaltungen geraden Gate-Leitungen der 2n Gate-Leitungen bereitgestellt wird.

3. Anzeigevorrichtung nach Anspruch 2, wobei die Signalleitungen auf derselben Schicht wie die Datenleitungen (DL) angeordnet sind und/oder aus demselben Material wie die Datenleitungen (DL) hergestellt sind.

4. Anzeigevorrichtung nach einem der vorhergehenden Ansprüche 1 bis 3, wobei sich die Signalleitungen in der ersten Richtung erstrecken.

5. Anzeigevorrichtung nach einem der vorhergehenden Ansprüche, wobei die GIP-Schaltung ferner eine erste und/oder eine zweite Knotenleitung enthält, die zwischen zwei benachbarten Pixelzeilen angeordnet sind.

6. Anzeigevorrichtung nach Anspruch 5, wobei die erste und/oder die zweite Knotenleitung von den Gate-Leitungen (GL) beabstandet sind und/oder auf derselben Schicht wie die Gate-Leitungen (GL) angeordnet sind und/oder aus demselben Material wie die Gate-Leitungen (GL) hergestellt sind.

7. Anzeigevorrichtung nach Anspruch 5, wobei die erste und/oder die zweite Knotenleitung eine der Gate-Leitungen (GL) überlappend angeordnet sind und auf einer von jener der Gate-Leitungen (GL) verschiedenen Schicht angeordnet sind.

8. Anzeigevorrichtung nach einem der vorhergehenden Ansprüche 5 bis 7, wobei sich die erste und/oder die zweite Knotenleitung in der zweiten Richtung erstrecken.

9. Anzeigevorrichtung nach Anspruch 1, wobei eine i-te GIP-Schaltung, die konfiguriert ist, ein Gate-Signal an eine i-te Gate-Leitung auszugeben, wobei i eine Ganzzahl größer als 2 ist, Folgendes umfasst:
einen ersten Transistor, der mit einer (i - 1)-ten Gate-Leitung und der ersten Knotenleitung (QL) verbunden ist;
einen zweiten Transistor, der mit der ersten Knotenleitung (QL) und der Niederpegelspannungsleitung (VSS) verbunden ist;
einen dritten Transistor, der mit der ersten Taktsignalleitung (CLK1) und der ersten Knotenleitung (QL) verbunden ist;
einen vierten Transistor, der mit der zweiten Taktsignalleitung (CLK2), der Niederpegelspannungsleitung (VSS) und dem dritten Transistor verbunden ist; und
einen fünften Transistor, der mit der ersten Taktsignalleitung (CLK1) und dem dritten Transistor verbunden ist.

10. Anzeigevorrichtung nach einem der vorhergehenden Ansprüche, wobei jeder Transistor einer GIP-Schaltung zwischen zwei Pixelspalten angeordnet ist, die zwischen zwei benachbarten Datenleitungen (DL) angeordnet sind und/oder wobei die Transistoren einer GIP-Schaltung in der zweiten Richtung entlang einer der Gate-Leitungen (GL) angeordnet sind.

11. Anzeigevorrichtung nach einem der vorhergehenden Ansprüche, die ferner eine Datenansteuereinheit im nicht anzeigenden Bereich (NAA) umfasst, die konfiguriert ist, Datensignale an die Datenleitungen (DL) auszugeben.

12. Anzeigevorrichtung nach einem der vorhergehenden Ansprüche, wobei zwei Pixel einer Pixelzeile mit derselben Datenleitung verbunden sind, die dazwischen angeordnet ist, und/oder wobei die Pixel einer Pixelzeile abwechselnd mit einer ungeraden und einer geraden Gate-Leitung verbunden sind.

## Revendications

1. Dispositif d'affichage comportant :
un panneau d'affichage (100) incluant une zone d'affichage (AA) avec m × n pixels, chaque pixel incluant un transistor à couches minces (Tr), et une zone de non-affichage (NAA),
m/2 lignes de données (DL) agencées dans la zone d'affichage (AA) dans une première direction, m étant un nombre pair positif,
2n lignes de grille (GL) agencées dans la zone d'affichage (AA) dans une seconde direction, n étant un entier supérieur à 5, dans lequel les lignes de grille (GL) et les lignes de données (DL) se croisent mutuellement pour définir les m × n pixels agencés dans m colonnes de pixels et n rangées de pixels ; et
2n circuits de grille dans panneau, GIP, agencés dans la zone d'affichage (AA), le circuit GIP incluant des transistors (T1, ..., T5),
dans lequel deux lignes de grille sont disposées entre deux rangées de pixels adjacentes, et deux colonnes de pixels sont disposées entre deux lignes de données adjacentes, et
dans lequel les transistors (T1, ..., T5) sont agencés entre des colonnes de pixels disposées entre deux lignes de données adjacentes,
dans lequel un premier circuit GIP (GIP1) configuré pour délivrer en sortie un signal de grille à une première ligne de grille (GL1) inclut :
un premier transistor (T1) ayant une grille de celui-ci connectée à une ligne de signal de début (Vst) et une première borne de celui-ci connectée à une première ligne de nœud (Q1), dans lequel la grille et une seconde borne du premier transistor (T1) sont connectées l'une à l'autre ;
un deuxième transistor (T2) ayant une grille de celui-ci connectée à une borne d'entrée de signal de grille (Vg2), une première borne de celui-ci connectée à la première ligne de nœud (Q1), et une seconde borne de celui-ci connectée à une ligne de tension à bas niveau (VSS) ;
un troisième transistor (T3) ayant une première borne de celui-ci connectée à une première ligne de signal d'horloge (CLK1) et une grille de celui-ci connectée à la première ligne de nœud (Q1) ;
un quatrième transistor (T4) ayant une grille connectée à une seconde ligne de signal d'horloge (CLK2), une première borne de celui-ci connectée à la ligne de tension à bas niveau (VSS), et une seconde borne de celui-ci connectée à une seconde borne du troisième transistor (T3) ;
un cinquième transistor (T5) ayant une première borne de celui-ci connectée à la première ligne de signal d'horloge (CLK1) et une seconde borne de celui-ci connectée à la seconde borne du troisième transistor (T3), dans lequel une grille et la seconde borne du cinquième transistor (T5) sont connectées l'une à l'autre ; et
un condensateur (C) connecté entre la première ligne de nœud (Q1) et la seconde borne du troisième transistor (T3) ;
dans lequel les lignes de signaux sont agencées entre des colonnes de pixels disposées entre deux lignes de données adjacentes.

2. Dispositif d'affichage selon la revendication 1, dans lequel une sortie de circuits GIP impairs des 2n circuits GIP est délivrée à des lignes de grille impaires des 2n lignes de grille, et une sortie de circuits GIP pairs des 2n circuits GIP est délivrée à des lignes de grille paires des 2n lignes de grille.

3. Dispositif d'affichage selon la revendication 2, dans lequel les lignes de signaux sont disposées sur une même couche que les lignes de données (DL) et/ou sont constituées d'un même matériau que les lignes de données (DL).

4. Dispositif d'affichage selon l'une quelconque des revendications 1 à 3 précédentes, dans lequel les lignes de signaux s'étendent dans la première direction.

5. Dispositif d'affichage selon l'une quelconque des revendications précédentes, dans lequel le circuit GIP inclut en outre au moins une ligne parmi des première et seconde lignes de nœud disposées entre deux rangées de pixels adjacentes.

6. Dispositif d'affichage selon la revendication 5, dans lequel au moins une des première et seconde lignes de nœud est espacée des lignes de grille (GL) et/ou est disposée sur une même couche que les lignes de grille (GL) et/ou est constituée d'un même matériau que les lignes de grille (GL).

7. Dispositif d'affichage selon la revendication 5, dans lequel au moins une des première et seconde lignes de nœud est agencée en recouvrant l'une des lignes de grille (GL) et est disposée sur une couche différente des lignes de grille (GL).

8. Dispositif d'affichage selon l'une quelconque des revendications 5 à 7 précédentes, dans lequel les premières et/ou secondes lignes de nœud s'étendent dans la seconde direction.

9. Dispositif d'affichage selon la revendication 1, dans lequel un i^{ème} circuit GIP configuré pour délivrer en sortie un signal de grille à une i^{ème} ligne de grille, i étant un entier supérieur à 2, inclut :
un premier transistor connecté à la (i-1)^{ème} ligne de grille et à la première ligne de nœud (QL) ;
un deuxième transistor connecté à la première ligne de nœud (QL) et à la ligne de tension à bas niveau (VSS) ;
un troisième transistor connecté à la première ligne de signal d'horloge (CLK1) et à la première ligne de nœud (QL) ;
un quatrième transistor connecté à la seconde ligne de signal d'horloge (CLK2), à la ligne de tension à bas niveau (VSS) et au troisième transistor ; et
un cinquième transistor connecté à la première ligne de signal d'horloge (CLK1) et au troisième transistor.

10. Dispositif d'affichage selon l'une quelconque des revendications précédentes, dans lequel chaque transistor d'un circuit GIP est agencé entre deux colonnes de pixels qui sont disposées entre deux lignes de données (DL) adjacentes et/ou dans lequel les transistors d'un circuit GIP sont agencés dans la seconde direction le long d'une des lignes de grille (GL).

11. Dispositif d'affichage selon l'une quelconque des revendications précédentes, comportant en outre une unité de commande de données dans la zone de non-affichage (NAA) et configurée pour délivrer en sortie des signaux de données aux lignes de données (DL).

12. Dispositif d'affichage selon l'une quelconque des revendications précédentes, dans lequel deux pixels d'une rangée de pixels sont connectés à une même ligne de données agencée entre ceux-ci et/ou dans lequel des pixels d'une rangée de pixels sont connectés de manière alternée à une ligne de grille impaire et à une ligne de données paire.
